# EUROPEAN PATENT SPECIFICATION

(11) **EP 0 486 829 B1**
(45) Date of publication and mention of the grant of the patent: **23.04.1997**
(21) Application number: 91118002.4
(22) Date of filing: 22.10.1991
(51) Int. Cl.: H01L 25/065, H01L 23/498, H01L 23/492, H01L 21/60, H01L 25/18, H01L 25/10, G06F 15/78

(54) **Semiconductor device and semiconductor device packaging system**
Halbleiteranordnung und Verpackungssystem für Halbleiteranordnung
Dispositif semi-conducteur et système d'empaquetage pour dispositif semi-conducteur

(30) Priority: 22.10.1990 JP 283762/90
(43) Date of publication of application: 27.05.1992
(73) Proprietor: SEIKO EPSON CORPORATION, Shinjuku-ku Tokyo-to (JP)
(72) Inventor: Tsukamoto, Takashi, c/o Seiko Epson Corporation, Suwa-shi, Nagano-ku (JP); Abe, Sachiyuki, c/o Seiko Epson Corporation, Suwa-shi, Nagano-ku (JP); Yabushita, Tetsuo, c/o Seiko Epson Corporation, Suwa-shi, Nagano-ku (JP); Hayashi, Yoshimitsu,c/o Seiko Epson Corporation, Suwa-shi, Nagano-ku (JP)
(74) Representative: Hoffmann, Eckart, Dipl.-Ing.

(56) References cited:
- FR-A- 2 193 509
- FR-A- 2 244 207
- GB-A- 2 053 566
- US-A- 3 984 813
- US-A- 4 953 060
- PATENT ABSTRACTS OF JAPAN, vol. 12, no. 177 (E-613) 25 May 1988; & JP-A-62 285 434
- PATENT ABSTRACTS OF JAPAN, vol. 6, no. 55 (E-101) 10 April 1982; & JP-A-56 167 340
- PATENT ABSTRACTS OF JAPAN, vol. 12, no. 207 (E-621) 14 June 1988; & JP-A-63 004 633
- PATENT ABSTRACTS OF JAPAN, vol. 13, no. 393 (E-814) 31 August 1989; & JP-A-01 138 725
- PATENT ABSTRACTS OF JAPAN, vol. 13, no. 525 (E-850) 22 November 1989; & JP-A-01 214 035
- PATENT ABSTRACTS OF JAPAN, vol. 10, no. 79 (E-391) 28 March 1986; & JP-A-60 225 438
- PATENT ABSTRACTS OF JAPAN, vol. 14, no. 234 (E-092) 17 May 1990; & JP-A-02 062 069
- PATENT ABSTRACTS OF JAPAN, vol. 14, no. 387 (E-0967) 21 August 1990; & JP-A-02 142 151
- PATENT ABSTRACTS OF JAPAN, vol. 14, no. 336 (E-0953) 19 July 1990; & JP-A-02 113 543
- PATENT ABSTRACTS OF JAPAN, vol. 8, no. 200 (E-266) 13 September 1984; & JP-A-59 088 852
- PATENT ABSTRACTS OF JAPAN, vol. 10, no. 217 (E-423) 29 July 1986; & JP-A-61 054 656
- PATENT ABSTRACTS OF JAPAN, vol. 11, no. 148 (E-506) 14 May 1987; & JP-A-61 287 133
- PATENT ABSTRACTS OF JAPAN, vol. 14, no. 472 (P-1116) 15 October 1990; & JP-A-02 187 880

## Description

### Background of the present invention

### Industrial Field of Use

The present invention relates to a semiconductor device and a semiconductor packaging system of computer systems and more particularly to structures that allow some flexibility in computer architectures so that program and command word-lengths can be easily adjusted.

### Description of the Prior Art

Central processing units (CPUs) are conventionally comprised of a basic control unit, an arithmetic logic unit (ALU), and several general/special purpose registers. All of which elements are now routinely integrated on a single monolithic semiconductor substrate as a direct result of advancements in semiconductor processing technology. The control unit, ALU, and registers are usually interconnected by various proprietary kinds of intra-chip buses (sometimes called micro-buses). Program commands and I/O data flow over these buses. The internal connections between the elements dramatically reduce the number of external connections that would otherwise be necessary. Quality and reliability experts have a rule-of-thumb that says a reduction in the number of external pins and their PC board connections will be directly reflected in an improvement in a system's reliability. Individual device reliability is often computed on the basis of how many pins the IC's in a system have. But high levels of integration reduce the flexibility a system designer has with customizing the architecture for particular applications. Since the interconnects are on-chip, they are not accessible to board and systems designers. So these engineers are stuck with whatever the chip designer decided to offer as a general compromise between conflicting applications that were envisioned at the time the chip was specified.

Each section and interconnect of a monolithic semiconductor CPU, quite naturally, has a fixed composition. Each CPU must therefore have a standardized fixed command (instruction) set. But non-monolithic implementations, even though they allow relatively mixing and matching each of the elements of a central processing unit, have serious disadvantages. For example, the required complex interconnections invite high failure rates. Being able to select a system optimal to its application is very compelling and can tip the scales in that direction.

A major advantage of semiconductor integrated circuit technology is that many electronic elements are microminiaturized at the same time in a single array. However, central processing units rarely have flat, non-hierarchical structures. For example, a command register receives program commands from program memory and then sends these commands to a command decoder. The command decoder deciphers the program commands and sends out micro-commands (also called microcode). More complex and larger instructions can make use of wider microcodes, and do more in parallel. Fewer instructions are needed to implement each step in a program. A reduction in power consumption is possible if the number of elements in a command that must be fetched can be reduced. Conversely, if the length of a command word is made shorter, the processing of the command can be reduced, because the decoding is less complicated, and timing generators can be simplified. High-speed processing is possible because faster clocks can be used.

The document JP-A-1-138725 discloses a process of manufacturing chip packages in which hybride integrated circuit substrates are mounted on a tape carrier after which the carrier is cut so that individual packages each including one semiconductor chip are obtained.

The document JP-A-2-113543 discloses a semiconductor device having two LSI chips arranged side by side and interconnected by means of two wiring layers formed on a film tape.

The document GB-A-2 053 566 discloses an integrated circuit package provided with a socket arrangement into which a second integrated circuit package may be plugged.

The document US-A-3,984,813 discloses a microprocessor system having at least two separate LSI chips one including a central processing unit which requires an external program counter, and the other one including a memory for storing the instruction codes and a program counter for addressing the memory.

The document JP-A-61-287133 discloses a semiconductor device including within one package three separate chips stacked one upon the other and interconnected by means of wire bonding. One chip includes a large scale memory element, another one a central processing control element and a third one a programming memory.

It is an object the present invention to provide a central processing unit allowing it to easily change the command and instruction sets to allow for flexibility of a system designer to customize the architecture for particular applications.

This object is achieved with a central processing unit as claimed in claims 1, 4 and 7, respectively.

Preferred embodiments of the invention are subject-matter in the dependent claims.

An advantage of the present invention is that various program command word lengths can be accommodated by swapping in different first chips.

Another advantage of the present invention is that if the word lengths of commands in a program memory are long enough, arithmetic operations can be executed in one command fetch. This reduces the overall program fetch time used.

Another advantage of the present. invention is that there can be a significant reduction in power consumption and consequently a longer battery life.

Another advantage of the present invention is that if the command word lengths in program memory are short, high speed processing is possible because of a simpler timing generator can be implemented.

Another advantage of the present invention is that the word lengths in program memory can be easily increased.

Another advantage of the present invention is that a variety of second chips can be produced each in small lots, and the first chip can be produced in one version and in quantity. Depending on how they are combined, a low cost and diversified computer can be offered by tailoring the product to the application in which it will be used.

Another advantage of the present invention is that the two-chip construction solves the heat generation problem, and higher speeds, compared to single-chip devices; are possible.

Other objects and attainments together with a fuller understanding of the present invention will become apparent and appreciated by referring to the following description and claims taken in conjunction with the accompanying drawings.

### Brief Description of the Drawings

Fig. 1 is a functional block diagram of a variable word length computer system, according to a first embodiment of the present invention;
Fig. 2 is a block diagram of a program counter block in the computer system of Fig. 1;
Fig. 3 is a timing chart of various system clocks generated by the timing generator of the ALU/register chip of the computer system of Fig. 1;
Fig. 4A is a cross section of a wire-bonded chip-on-board type of package for the computer system of Fig. 1;
Fig. 4B is a view of the active surface of chip 100 showing pads (contacts) arranged in two concentric squares about the periphery. The clockwise arrow represents the direction of increasing pin numbers;
Fig. 4C is a view of the active surface of chip 200 showing pads (contacts) arranged in a square about the periphery. The counter-clockwise arrow represents the direction of increasing pin numbers and matches that of Fig. 4B when chips 100 and 200 are assembled face-to-face as in Fig. 4A ;
Fig. 5 is a cross section of a package similar to that of Fig. 4A, but with an anistropic layer connecting chip 100 to chip 200;
Fig. 6A is a top view of a tape automated bonded (TAB) type chip-on-board type of package for the computer system of Fig. 1;
Fig. 6B is a cross sectional diagram of the package of Fig. 6A taken along the line 6B-6B. This cross-section intersects certain printed wires connecting chip 100 to chip 200;
Fig. 6C is a cross sectional diagram of the package of Fig. 6A taken along the line 6C-6C. This cross-section intersects certain printed wires connecting the substrate and chip 100;
Fig. 7 is a cross sectional diagram of a pair of stackable PGA packages for the computer system of Fig. 1;
Fig. 8 is three dimensional perspective view of the packages of Fig. 7;
Fig. 9 is a cross section of a surface mount type of QFP package mounted on a PGA type package, the pair containing chips 100 and 200 for the computer system of Fig. 1; and
Fig. 10 is three dimensional perspective view of the packages of Fig. 9.

### Description of the Preferred Embodiments

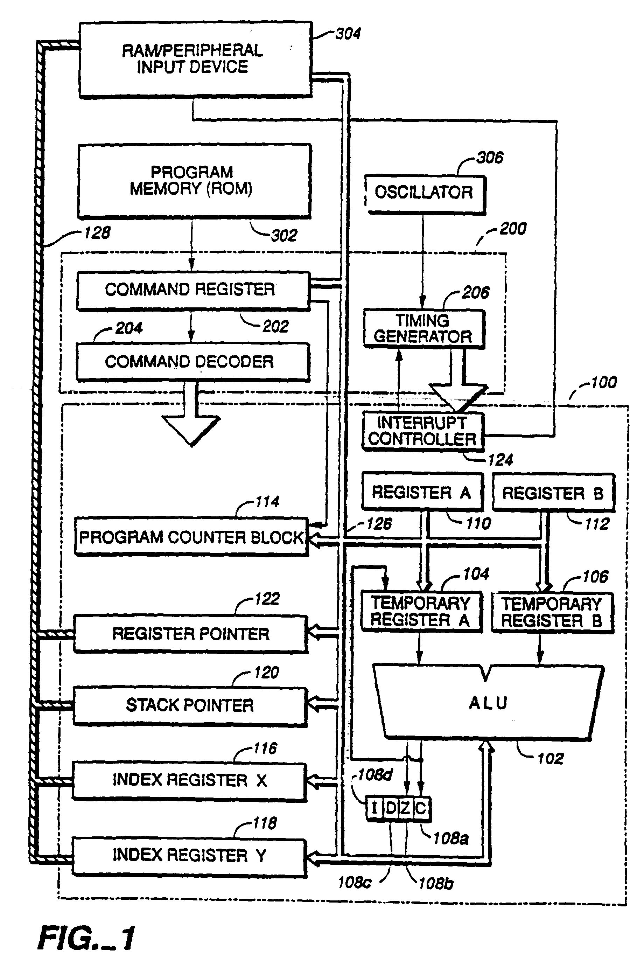

In Fig. 1, a first embodiment of the present invention is a variable word length computer system, comprised of two major parts, a 4-bit "general purpose" chip 100 and an ALU/register chip 200. Preferably, chips 100 and 200 are sealed together in the same device package. General purpose chip 100 has an arithmetic logic unit (ALU) 102; registers 104, 106, 110, and 112; a program counter 114; index registers 116 and 118; a stack pointer 120; a register pointer 122; and an interrupt controller 124. ALU 102 performs arithmetic operations between (4-bit) data stored in temporary registers 104 and 106. ALU 102 can do addition with carry (ADD), addition without carry (ADC), subtraction with borrow (SUB), subtraction without borrow (SBC), logical AND (AND), logical OR (OR), exclusive logical OR (XOR) comparison (CP), bit test (FAN), right rotation with carry (RRC), left rotation with carry (RLC), inversion (NOT), and more. When the arithmetic operation results of ALU 102 are all zero, a "Z" flag 108b (zero flag) will be set. When an addition carry result is generated and when a subtraction borrow is generated, a "C" flag 108a (carry flag) will be set. By setting a "D" flag 108c (digital flag), for decimal arithmetic operations mode, addition and subtraction will be BCD. Registers 110 and 112 are each 4-bit general purpose registers and function as accumulators. Chip 200 is comprised of a command register 202, a command decoder 204, and a timing generator 206. A program memory 302 supplies macrocode to command register 202. An oscillator 306 clocks timing generator 206.

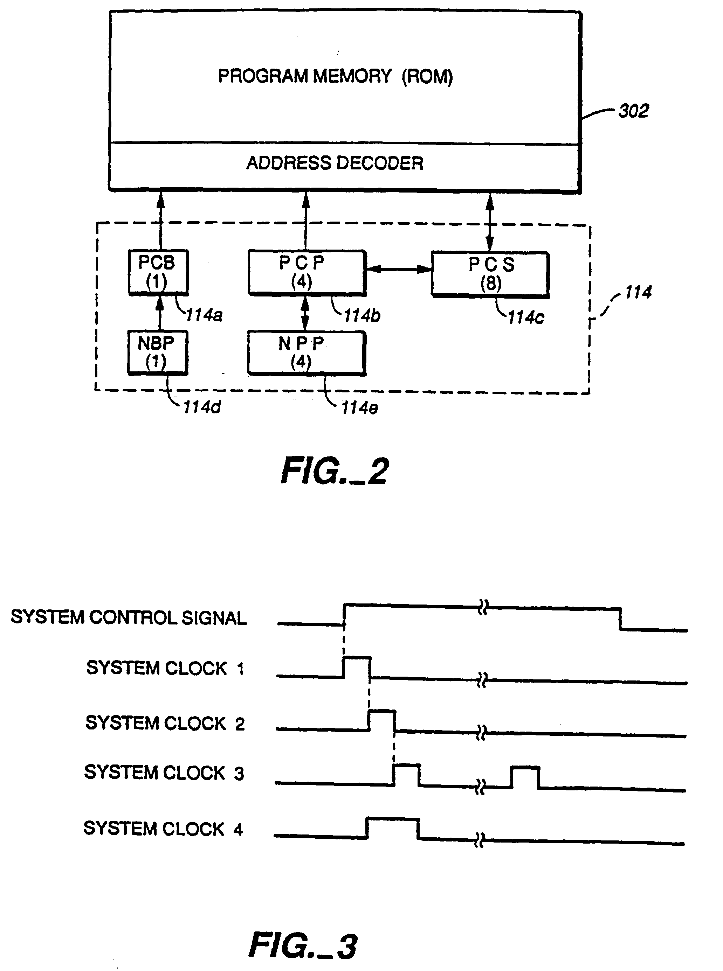

In Fig. 2, program counter 114 comprises two registers and three counters that address for command register 202 the various memory areas of program memory 302, described below. A program counter bank (PCB) 114a is a 1-bit counter that designates a program memory bank area. A program counter page (PCP) 114b is a 4-bit counter of the program memory page area. A program counter step (PCS) 114c is an 8-bit counter that designates the memory word step area. The program memory address therefore comprises 13 bits. A new bank pointer (NBP) 114d is a 1-bit register used for a branch destination bank address. When a branch command has been executed, the value of new bank pointer (NBP) 114e is loaded into program counter bank 114a. New page pointer (NPP) 114e is used for a page section register. When a branch command is executed, a value for the new page pointer 114e is loaded into program counter page 114b. Index register 116 is comprised of a 4-bit page section register and an 8-bit pre-settable counter. A maximum of 4,096 words can be specified. Index registers 118 and 116 are similar, and each has a 4-bit page section register and an 8-bit presettable counter. A maximum of 4,096 words can be specified. Stack pointer 120 is an 8-bit register that designates data memory stack address. Register pointer 122 is a 4-bit register for the data memory register address. Interrupt controller 124 can generate a maximum of 15 interrupt vectors for various interrupt requests from peripherals and internal elements. An interrupt enable/disable is specified by means of interrupt flag "I" 108d. When the "I" flag 108d is set, interrupts are enabled. When it is reset, interrupts are disabled. A bus 126 is a 4-bit data bus and a bus 128 is an 8-bit address bus.

Command register 202 receives fetches of commands from program memory 302. Command decoder 204 then decodes the (macro) command codes and generates corresponding microcode comprised of many different basic control signals Among the control signals are a program counter control signal, a system control signal, an arithmetic operation control signal, a register control signal, a memory control signal, a flag control signal, a stack pointer control signal, a RAM expansion index register control signal, et cetera. Timing generator 206 produces a number of different system clocks that respond to commands that have different numbers of command cycles. For example, in Fig. 3, the first through fourth system clocks depend on particular system control signals that are then in effect.

The program instruction set (command repertory) influence: the makeup of control signals from command decoder 204, the bit length of command register 202, and the bit length of the system clock of timing generator 206, all of which are on the ALU/register chip 200. The internal composition of general purpose chip 100 does not change, even if different instruction sets are being used. If the word length of the commands in the program memory is long, a savings in battery power consumption can be realized. ALU/register chip 200 is combined with general purpose chip 100. As such, it is possible to execute several arithmetic logic operations with one command fetch. In reducing the number of command fetches, a reduction in power consumption and a longer battery life results.

Conversely, when a high speed system is formed that requires only a limited amount of processing, the command words can be shortened, and ALU/register chip 200, which corresponds to the, is combined with general purpose chip 100. Higher speed processing can be accomplished by means of the simplification of timing generator 206 and the simplification of command decoder 204 in terms of ALU/register chip 200 in the case.

In a 4-bit CPU, there are typically 70 control signals that must be output from command decoder 204, and 40 system clock lines output from timing generator 206.

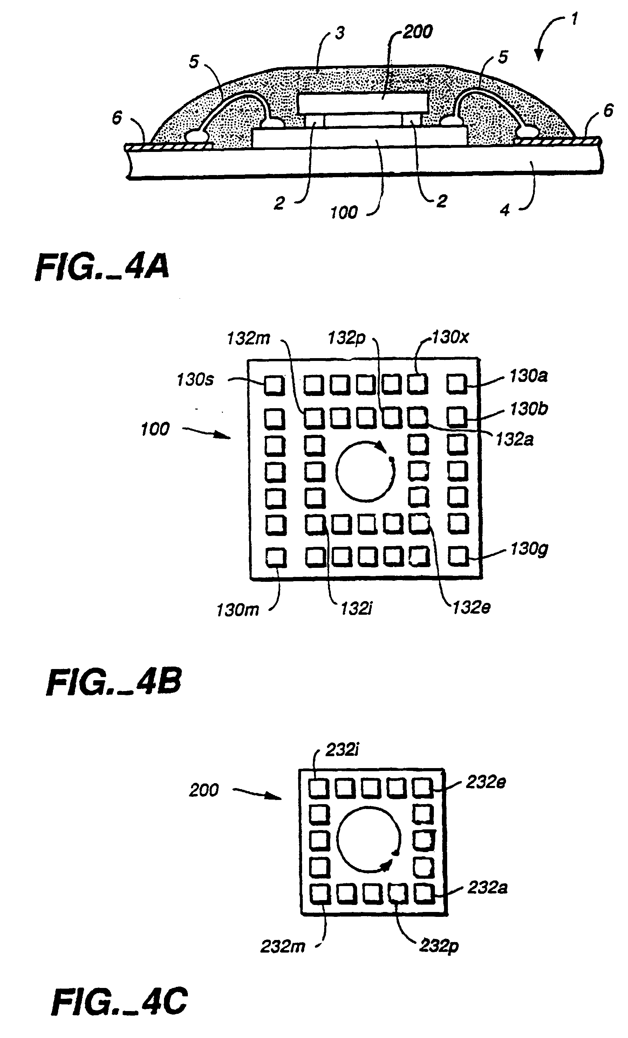

Fig. 4A shows a cross section of a package 1 comprising general purpose chip 100, which is mounted to a substrate 4. Chip 200 is stacked on top of general purpose chip 100. In Fig. 4B, pads on the surface of chip 100 make external connections to pads 130a through 130x. In Fig. 4C, pads 232a through 232p are located on one surface of chip 200. Pads 232a to 232p are laid out such that they line up with inter-chip connecting pads 132a to 132p. Pads 130a to 130x are connected to a plurality of printed circuits 6 through a plurality of bonding wires 5. Within printed circuit 6 are the data bus 126 and an address bus 128. Chip 200 has its active surface facing the active surface of chip 100. Pads 232a to 232p of chip 200 and the inter-chip connection pads 132a to 132p are coupled by a silver paste 2 that can have sufficient bonding strength, if a heat hardened silver paste is used. Control signals from chip 200 that are not used by chip 100 (e.g., memory control signals) simply pass through to the bonding wires and the printed circuits. A clock from oscillator 306 (Fig. 1) passes through the printed circuits, bonding wires, the pads, the wiring within chip 100, the inter-chip connecting pads and chip 200. In order to protect chips 100 and 200 and to protect bonding wires 5, they are covered with a resin molding material 3.

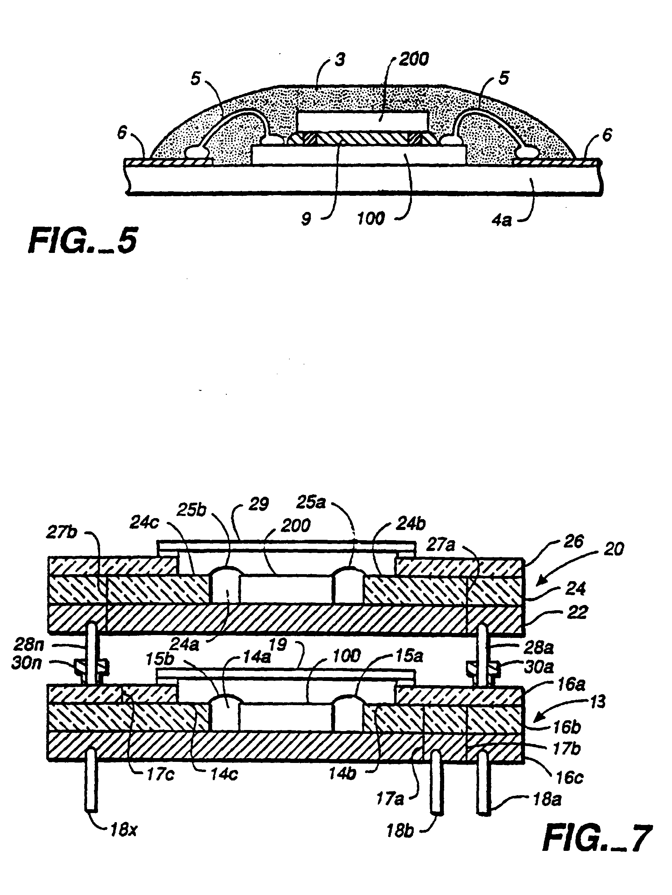

Fig. 5 shows an anisotropic conductive material 9 being used in place of silver paste 2 in the gap between chip 100 and Chip 200. Material 9 conducts only across the film thickness in one direction, and only corresponding pads will be interconnected connected.

Operating speed will be reduced if the signal connection length between chip 100 and chip 200 is too long, because the line resistance and line capacitance will increase. But in the present invention, the two chips have their active surfaces facing toward each other and the corresponding pads are connected. This makes for an extremely short connection length. So, line resistance and line capacitance will be insignificant.

With the above construction, a quick response to new applications is possible. The is possible by starting with a uncompleted product, having only chip 100 on substrate 4, and choosing a new ALU/register chip from among a series of chips.

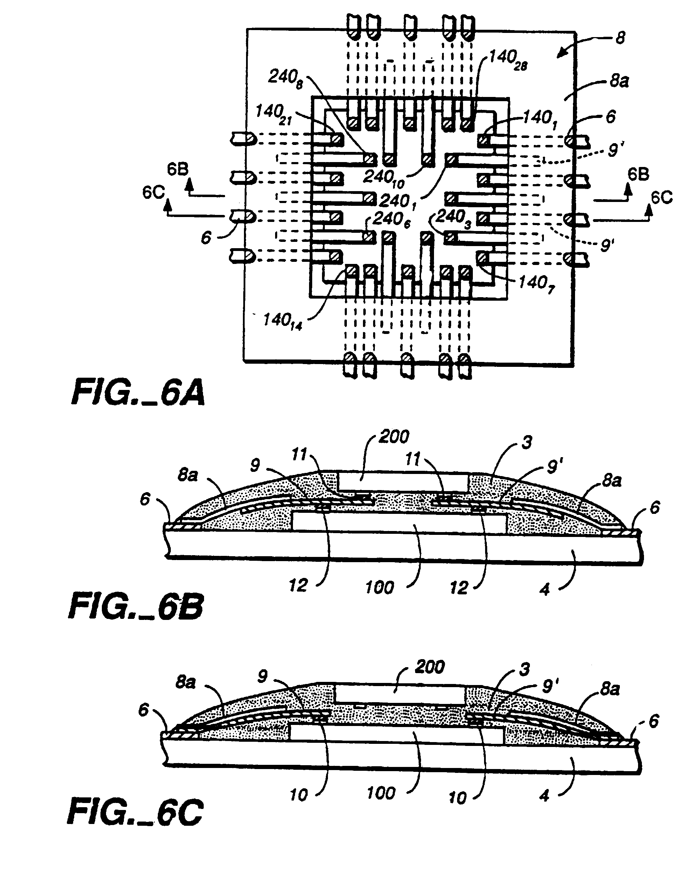

Figs. 6A-6C show a second way to package parts of the computer system of Fig. 1. A flexible circuit 8 having flex wires 9' makes the necessary connections between the outside and chips 100 and 200 (instead of bonding wires). Fig. 6B is a cross-section that shows how wires 9' interconnect chips 100 and 200 and are carried by a film portion 8a attached to substrate 4 via circuit 6. Fig. 6C is a cross-section that shows how wires 9' interconnect chip 100 with the outside. A plurality of pads 140₁ through 140₂₈ are positioned in a square pattern at a predetermined pitch (lead spacing) along the perimeter of chip 100. Pads 240₁ to 240₁₀ are also grouped in a square on chip 200, which is smaller than its counterpart on chip 100. The latter are set at a second predetermined pitch, which may or may not be the same as the first pitch. In Fig. 6C, a connection is made between the pads on chip 100 and printed circuit 6 by flexible circuit 8. The one end of each of wires 9' connect to the pads via bumps 10. In Fig. 6B, bumps 11 connect the pads of chip 200 to printed circuit wires 9' which then connect with bumps 12. Printed wires 9' are supported by flexible film 8a. Chip 200 is initially supported in its mid-air position above chip 100 during the packaging process by wires 9'. Then, in order to add strength and protection from the environment, chips 100 and 200 are encapsulated in a resin molding material 3 (e.g., epoxy).

In the packaging process, chip 100 has flexible circuit 8 aligned on top. Inner edges of printed wires 9' are gang bonded to the pads on chip 100. Prior to soldering, bumps 11 are formed on the pads of chip 200. Chip 200 is then aligned with flexible circuit 8, and the pads of chip 200 are reflow soldered to wires 9'. The outer edges of printed wires 9' and printed circuit 6 are connected. Then resin 3 is molded to cover and fortify the delicate chips and their connections.

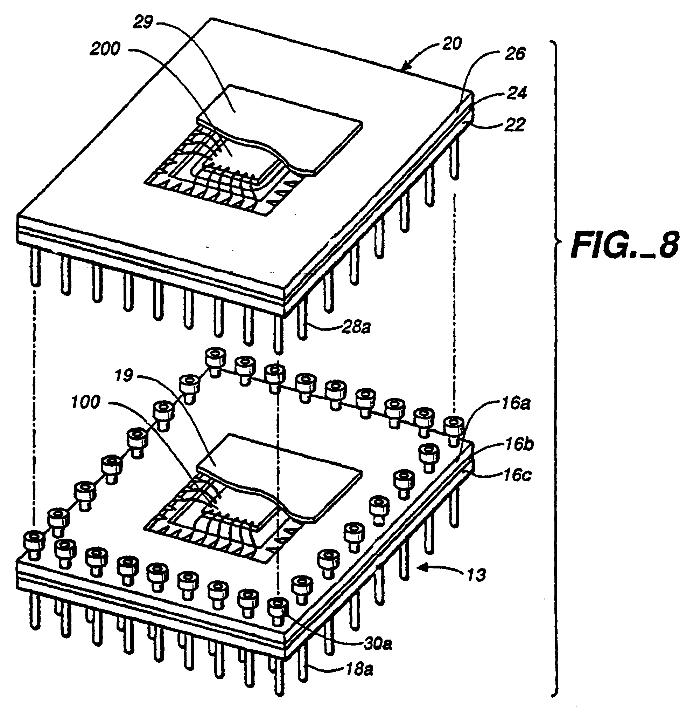

Figs. 7 and 8 show a third embodiment of the present invention that can be used to package part of the computer system of Fig. 1. A pin grid array package (PGA) 20 is stacked onto a PGA 13, which has three ceramic layers 16a, 16b and 16c. A plurality of pins 18a to 18x are assembled into layer 16c. A cavity 14a allows chip 100 to be fixed in the middle. Center ceramic layer 16b and upper ceramic layer 16 have wiring patterns 14b and 14c formed in gold, and are connected to with bonding wires 15a and 15b. One end of gold wire pattern 14b connects to a through-hole plated wire 17a and to the base of pin 18b. Pin 18b is therefore electrically connected to chip 100. A lid 19 covers chip 100. PGA 20 also has three ceramic layers, these are layers 22, 24 and 26. Pins 28a to 28n are assembled into lower ceramic layer 22. Chip 200 is mounted in chip cavity 24a near the middle of ceramic layer 24. Gold wiring patterns 24b and 24c are routed between layers 24 and 26. Bonding wires 25a and 25b connect the pads on chip 200 with gold wiring patterns 24b and 24c. Gold wiring pattern 24b connects to pin 28a by a through-hole plated wire 27a. And, gold wiring pattern 24c is connected to pin 28n by a through-hole plated wire 27b. A plurality of sockets 30a to 30n are assembled in upper ceramic layer 16a. Pins 28a to 28n are such that they will fit into sockets 30a to 30n. For example, chip 200 connects to pin 18a via wire 27a, pin 28a, socket 30a and through-hole plated wire 17b. Chip 100 can be interconnected with chip 200, for example, by bonding wire 25b, plated wire 24c, through-hole wire 27b, pin 28n, socket 30n, through-hole wire 17c, plated wire 14c and bonding wire 15b. Chip 200 is covered by lid 29.

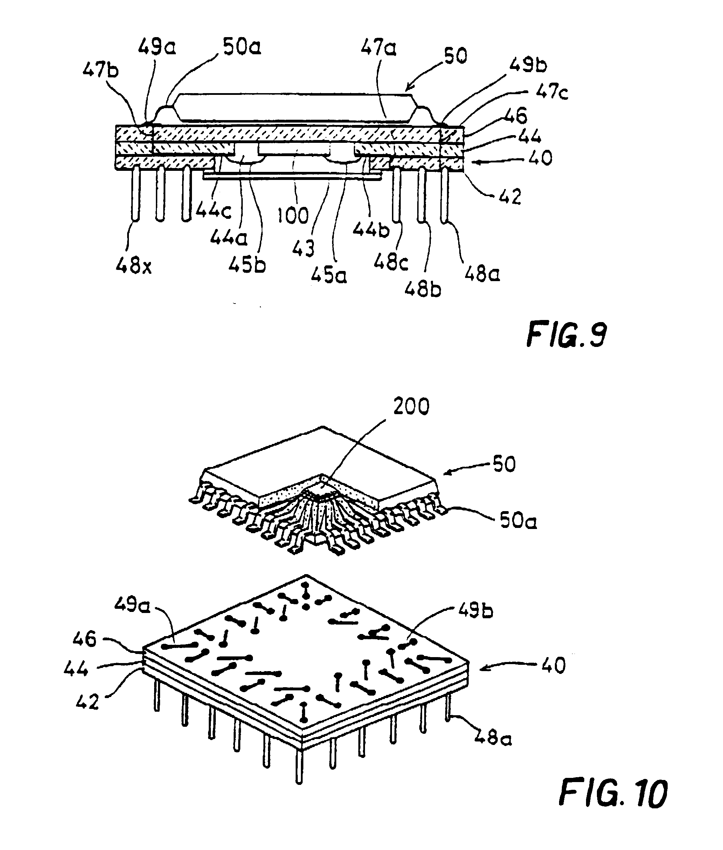

Figs. 9 and 10 represent an example not forming part of the present invention of a package that can house part of the computer system of Fig. 1. Fig. 10 show a diagonal exploded view of the number of the same structure. A quad flat package (QFP) 50 is soldered to the top of a PGA package 40. PGA 40 has three stacked ceramic layers 42, 44 and 46, similar to PGA 13. Pins 48a to 48x are assembled in lower layer 42. Chip 100 is mounted face down in chip cavity 44a, near the middle of ceramic layer 44. A predetermined wiring pattern is placed between the ceramic layers for interconnect. Gold wiring patterns 44b and 44c are positioned between lower and middle layers. The pads and the gold wiring patterns are connected by bonding wires 45a and 45b. For example, gold wiring pattern 44b is connected to pin 48c by through-hole plated wire 47a. Gold wiring pattern 44c is connected to gold wiring pattern 49a of upper layer through though hole plated wire 47b. Gold wiring pattern 49b is connected to pin 48a by through-hole plated wire 47c. QFP package 50 houses ALU/register chip 200. A plurality of outer leads 50a match up with respective wiring patterns (e.g., patterns 49a and 49b) on the top of ceramic layer 46. Bonding of QFP 50 to PGA 40 can be done with a conventional solder reflow method. Chip 100 is mounted upside down in cavity 44a and is covered by lid 43. The length of the outer leads 50a are shorter than those of PGA 20 (Fig. 7). So the interconnect of chips 100 and 200 is shorter. As a result, even though there are two discrete packages, the wiring capacitance and resistance between chips 100 and 200 are significantly reduced from what would otherwise exist.

Thus, the present invention described herein is intended to embrace all such alternatives, modifications, applications and variations as may fall within the spirit and scope of the appended claims.

## Claims

1. A central processing unit device, comprising:
a substrate (4, 4a);
a printed circuit (6) on the substrate;
a first semiconductor chip (100) of a general purpose type including an arithmetic logic unit (102), at least one register (110, 112), a stack pointer (120), a program counter (114), and an index register (116, 118) and having pads (130a-130x) for wire bonding to make external connections and contacts (132a-132p) for chip-to-chip interconnection on its active surface; and
a second semiconductor chip (200) configured for a particular application, including a command register (202), a command decoder (204), and a timing generator (206) and having contacts (232a-232p) for chip-to-chip interconnection on its active surface,
wherein the first and second chips are stacked one upon the other on said substrate with their active surfaces facing each other and with the respective contacts for chip-to-chip interconnection connected via a connector means.

2. The device of claim 1, wherein:
said connection of the first and second semiconductor chips is accomplished by coupling said contacts with a heat-hardened silver paste (2).

3. The device of claim 1, wherein:
respective contacts (132a-132p, 232a-232p) on the first and second semiconductor chips (100, 200) are coupled together via an anisotropic conductive material (9).

4. A central processing unit device, comprising:
a substrate (4);
a printed circuit (6) on the substrate;
a first semiconductor chip (100) of a general purpose type including an arithmetic logic unit (102), at least one register (110, 112), a stack pointer (120), a program counter (114), and an index register (116, 118) and having pads (140₁-140₂₈) for bonding;
a second semiconductor chip (200) configured for a particular application, including a command register (202), a command decoder (204), and a timing generator (206) and having pads (240₁-240₁₀) for bonding; and
a flexible circuit (8) having a first plurality of printed wires (9') that electrically couple pads on the first semiconductor chip with pads on the second semiconductor chip, the flexible circuit having a second plurality of printed wires (9') that electrically couple pads on the first semiconductor chip with the printed circuit on the substrate;
wherein the first and second chips are stacked one upon the other on said substrate.

5. The device of any of the preceding claims, wherein the first and second semiconductor chips (100, 200) are encapsulated in an epoxy resin.

6. The device of any of the preceding claims, wherein the first and second semiconductor chips (100, 200) each have active surfaces facing one another.

7. A central processing unit device, comprising:
a first package (13) having;
first, second, and third ceramic layers (16a, 16b, 16c);
a plurality of connector pins (18a-18x) in the first ceramic layer (16c);
a plurality of sockets (30a-30n) in the third ceramic layer (16a);
a first semiconductor chip (100) of a general purpose type including an arithmetic logic unit (102), at least one register (110, 112), a stack pointer (120), a program counter (114), and an index register (116, 118), said first semiconductor chip being mounted in a cavity in the second and third ceramic layers;
a first lid (19) that covers the first semiconductor chip;
a first connection means for electrically connecting the first semiconductor chip to respective sockets, the connection means comprising bonding wires, plated through-holes in the third ceramic layer, and printed circuits;
a second connection means for electrically connecting the first semiconductor chip to respective connector pins, the connection means comprising bonding wires, plated through-holes in the first ceramic layer, and printed circuits;
a second package (20) having;
fourth, fifth, and sixth ceramic layers (22, 24, 26);
a plurality of connector pins (28a-28n) in the fourth ceramic layer (22) such that they mate with the plurality of sockets in the third ceramic layer of the first package;
a second semiconductor chip (200) configured for a particular application and including a command register (202), a command decoder (204), and a timing generator (206), said second semiconductor chip being mounted in a cavity in the fifth and sixth ceramic layers;
a second lid (29) that covers the second semiconductor chip;
a third connection means for electrically connecting the second semiconductor chip to respective connector pins in the fourth ceramic layer, the connection means comprising bonding wires, plated through-holes in the fourth ceramic layer, and printed circuits;
wherein the second package is stacked upon the first package with said plurality of connector pins of the second package received in said plurality of sockets of the first package.

8. The device of claim 7 wherein said second connection means includes plated through-holes (17a, 17b) in the first and second ceramic layers (16c, 16b), and said third connection means includes plated through-holes (27a, 27b) in the fourth and fifth ceramic layers (24, 26)

9. The device of any of the preceding claims, wherein:
said program counter (114) comprises a program counter bank (114a), a program counter page (114b), a program counter step (114c), a new bank pointer (114d), and a new page pointer (114e).

## Patentansprüche

1. Zentraleinheitsvorrichtung, umfassend:
ein Substrat (4, 4a);
eine gedruckte Schaltung (6) auf dem Substrat,
einen ersten Halbleiterchip (100) eines Allzwecktyps, der eine arithmetische Logikeinheit (102), wenigstens ein Register (110, 112), einen Stapelzeiger (120), einen Programmzähler (114) und ein Indexregister (116, 118) enthält und Anschlußflächen (130a-130x) zum Drahtbonden zur Herstellung externer Verbindungen sowie Kontakte (132a-132p) für die Verbindung der Chips untereinander auf seiner aktiven Oberfläche aufweist; und
einen zweiten Halbleiterchip (200), der für eine bestimmte Anwendung konfiguriert ist, ein Befehlsregister (202), einen Befehlsdecoder (204) und einen Zeittaktgenerator (206) enthält und Kontakte (232a-232p) für die Verbindung der Chips untereinander auf seiner aktiven Oberfläche aufweist, wobei der erste und der zweite Chip auf dem Substrat aufeinandergestapelt sind, wobei ihre aktiven Oberflächen einander zugewandt sind und die jeweiligen Kontakte für die Verbindung der Chips untereinander über ein Kontaktmittel verbunden sind.

2. Vorrichtung nach Anspruch 1, bei dem die Verbindung des ersten und des zweiten Halbleiterchips durch Koppeln der Kontakte mit einer wärmehärtenden Silberpaste 2 bewirkt ist.

3. Vorrichtung nach Anspruch 1, bei der jeweilige Kontakte (132a-132p, 232a-232p) an dem ersten und dem zweiten Halbleiterchip (100, 200) miteinander über ein anisotropes leitendes Material (9) gekoppelt sind.

4. Zentraleinheitsvorrichtung, umfassend:
ein Substrat (4);
eine gedruckte Schaltung (6) auf dem Substrat;
einen ersten Halbleiterchip (100) eines Allzwecktyps, der eine arithmetische Logikeinheit (102), wenigstens ein Register (110, 112), einen Stapelzeiger (120), einen Programmzähler (114) und ein Indexregister (116, 118) enthält und Anschlußflächen (140₁-140₂₈) zum Bonden aufweist;
einen zweiten Halbleiterchip (200), der für eine bestimmte Anwendung konfiguriert ist, ein Befehlsregister (202), einen Befehlsdecoder (204) und einen Zeittaktgenerator (206) enthält und Anschlußflächen (240₁-240₁₀) zum Bonden aufweist; und
eine flexible Schaltung (8) mit einer ersten Vielzahl gedruckter Drähte (9'), die elektrische Anschlußflächen auf dem ersten Halbleiterchip mit Anschlußflächen auf dem zweiten Halbleiterchip koppeln, wobei die flexible Schaltung eine zweite Vielzahl gedruckter Drähte (9') aufweist, die elektrisch Anschlußflächen auf dem ersten Halbleiterchip mit der gedruckten Schaltung auf dem Substrat koppeln,
wobei der erste und der zweite Chip auf dem Substrat aufeinandergestapelt sind.

5. Vorrichtung nach einem der vorhergehenden Ansprüche, bei der der erste und der zweite Halbleiterchip (100, 200) in einem Epoxyharz verkapselt sind.

6. Vorrichtung nach einem der vorhergehenden Ansprüche, bei dem der erste und der zweite Halbleiterchip (100, 200) einander zugewandte aktive Oberflächen aufweisen.

7. Zentraleinheitsvorrichtung, umfassend:
eine erste Packung (13) mit
einer ersten, einer zweiten und einer dritten Keramikschicht (16a, 16b, 16c);
einer Vielzahl von Verbindungsstiften (18a-18x) in der ersten Keramikschicht (16c);
einer Vielzahl von Fassungen (30a-30n) in der dritten Keramikschicht (16a);
einem ersten Halbleiterchip (100) eines Allzwecktyps, der eine arithmetische Logikeinheit (102), wenigstens ein Register (110, 112), einen Stapelzeiger (120), einen Programmzähler (114) und ein Indexregister (116, 118) enthält, wobei der erste Halbleiterchip in einem Hohlraum in der zweiten und der dritten Keramikschicht montiert ist;
einem ersten Deckel (19), der den ersten Halbleiterchip bedeckt;
einer ersten Verbindungsanordnung zum elektrischen Verbinden des ersten Halbleiterchips mit den jeweiligen Fassungen, wobei die Verbindungsanordnung Bonddrähte, plattierte Durchgangslöcher in der dritten Keramikschicht und gedruckte Schaltungen umfaßt;
einer zweiten Verbindungsanordnung zum elektrischen Verbinden des ersten Halbleiterchips mit jeweiligen Verbindungsstiften, wobei die Verbindungsanordnung Bonddrähte, plattierte Durchgangslöcher in der ersten Keramikschicht und gedruckte Schaltungen umfaßt;
eine zweite Packung (20) mit
einer vierten, einer fünften und einer sechsten Keramikschicht (22, 24, 26);
einer Vielzahl von Verbindungsstiften (28a-28n) in der vierten Keramikschicht (22) derart, daß sie zu der Vielzahl von Fassungen in der dritten Keramikschicht der ersten Packung passen;
einem zweiten Halbleiterchip (200), der für eine bestimmte Anwendung konfiguriert ist und ein Befehlsregister (202), einen Befehlsdecoder (204) und einen Zeittaktgenerator (206) enthält, wobei der zweite Halbleiterchip in einem Hohlraum in der fünften und der sechsten Keramikschicht montiert ist,
einem zweiten Deckel (29), der den zweiten Halbleiterchip bedeckt;
einer dritten Verbindungsanordnung zum elektrischen Verbinden des zweiten Halbleiterchips mit jeweiligen Verbindungsstiften in der vierten Keramikschicht, wobei die Verbindungsanordnung Bonddrähte, plattierte Durchgangslöcher in der vierten Keramikschicht und gedruckte Schaltungen umfaßt;
wobei die zweite Packung auf die erste Packung gestapelt ist und die Vielzahl von Verbindungsstiften der zweiten Packung in der Vielzahl von Fassungen der ersten Packung aufgenommen sind.

8. Vorrichtung nach Anspruch 7, bei der die zweite Verbindungsanordnung plattierte Durchgangslöcher (17a, 17b) in der ersten und der zweiten Keramikschicht (16c, 16b) enthält und die dritte Verbindungsanordnung plattierte Durchgangslöcher (27a, 27b) in der vierten und der fünften Keramikschicht (24, 26) enthält.

9. Vorrichtung nach einem der vorhergehenden Ansprüche, bei der der Programmzähler (114) eine Programmzählerbank (114a), eine Programmzählerseite (114b), einen Programmzählerschritt (114c), einen Neue-Bank-Zeiger (114d) und einen Neue-Seite-Zeiger (114e) umfaßt.

## Revendications

1. Dispositif consistant en une unité centrale de traitement, comprenant :
un substrat (4, 4a);
un circuit imprimé (6) sur le substrat;
une première puce de semiconducteur (100) d'un type universel, comprenant une unité arithmétique et logique (102), au moins un registre (110, 112), un pointeur de pile (120), un compteur d'instructions (114), et un registre d'index (116, 118) et ayant des plages de connexion (130a-130x) pour le soudage de fils, pour établir des connexions externes, et des contacts (132a-132p) pour l'interconnexion de puce à puce sur sa surface active; et
une seconde puce de semiconducteur (200) ayant une configuration prévue pour une application particulière, comprenant un registre d'ordres (202), un décodeur d'ordres (204), et un générateur de signaux d'horloge (206), et ayant des contacts (232a-232p) pour l'interconnexion de puce à puce sur sa surface active,
dans lequel les première et seconde puces sont empilées l'une sur l'autre sur le substrat, avec leurs surfaces actives se faisant face, et avec les contacts respectifs pour l'interconnexion de puce à puce connectés par l'intermédiaire d'un moyen de connexion.

2. Dispositif suivant la revendication 1, dans lequel :
la connexion des première et seconde puces de semiconducteur est accomplie en accouplant les contacts précités avec une pâte à l'argent (2) durcie par la chaleur.

3. Dispositif suivant la revendication 1, dans lequel :
des contacts respectifs (132a-132p, 232a-232p) sur les première et seconde puces de semiconducteur (100, 200) sont couplés ensemble par l'intermédiaire d'un matériau conducteur anisotrope (9).

4. Dispositif consistant en une unité centrale de traitement, comprenant :
un substrat (4);
un circuit imprimé (6) sur le substrat;
une première puce de semiconducteur (100) d'un type universel, comprenant une unité arithmétique et logique (102), au moins un registre (110, 112), un pointeur de pile (120), un compteur d'instructions (114), et un registre d'index (116, 118), et ayant des plages de connexion (140₁-140₂₈) pour le soudage;
une seconde puce de semiconducteur (200) ayant une configuration prévue pour une application particulière, comprenant un registre d'ordres (202), un décodeur d'ordres (204), et un générateur de signaux d'horloge (206), et ayant des plages de connexion (240₁-240₁₀) pour le soudage; et
un circuit flexible (8) ayant un premier ensemble de conducteurs imprimés (9') qui connectent électriquement des plages de connexion sur la première puce de semiconducteur à des plages de connexion sur la seconde puce de semiconducteur, le circuit flexible ayant un second ensemble de conducteurs imprimés (9') qui connectent électriquement des plages de connexion sur la première puce de semiconducteur au circuit imprimé sur le substrat;
dans lequel les première et seconde puces sont empilées l'une sur l'autre sur le substrat.

5. Dispositif suivant l'une quelconque des revendications précédentes, dans lequel les première et seconde puces de semiconducteur (100, 200) sont encapsulées dans une résine époxy.

6. Dispositif suivant l'une quelconque des revendications précédentes, dans lequel chacune des première et seconde puces de semiconducteur (100, 200) a une surface active qui fait face à celle de l'autre.

7. Dispositif consistant en une unité centrale de traitement, comprenant :
un premier boîtier (13) ayant :
des première, seconde et troisième couches de céramique (16a, 16b, 16c);
un ensemble de broches de connecteur (18a-18x) dans la première couche de céramique (16c);
un ensemble de réceptacles (30a-30n) dans la troisième couche de céramique (16a);
une première puce de semiconducteur (100) d'un type universel comprenant une unité arithmétique et logique (102), au moins un registre (110, 112), un pointeur de pile (120), un compteur d'instructions (114), et un registre d'index (116, 118), cette première puce de semiconducteur étant montée dans une cavité dans les seconde et troisième couches de céramique;
un premier couvercle (19) qui recouvre la première puce de semiconducteur;
un premier moyen de connexion pour connecter électriquement la première puce de semiconducteur à des réceptacles respectifs, le moyen de connexion comprenant des fils à souder, des trous métallisés dans la troisième couche de céramique, et des circuits imprimés;
un second moyen de connexion pour connecter électriquement la première puce de semiconducteur à des broches de connecteur respectives, le moyen de connexion comprenant des fils à souder, des trous métallisés dans la première couche de céramique, et des circuits imprimés;
un second boîtier (20) ayant :
des quatrième, cinquième et sixième couches de céramique (22, 24, 26);
un ensemble de broches de connecteur (28a-28n) dans la quatrième couche de céramique (22), conçues pour s'adapter à l'ensemble de réceptacles dans la troisième couche de céramique du premier boîtier;
une seconde puce de semiconducteur (200) ayant une configuration prévue pour une application particulière et comprenant un registre d'ordres (202), un décodeur d'ordres (204), et un générateur de signaux d'horloge (206), cette seconde puce de semiconducteur étant montée dans une cavité dans les cinquième et sixième couches de céramique;
un second couvercle (29) qui recouvre la seconde puce de semiconducteur;
un troisième moyen de connexion pour connecter électriquement la seconde puce de semiconducteur à des broches de connecteur respectives dans la quatrième couche de céramique, le moyen de connexion comprenant des fils à souder, des trous métallisés dans la quatrième couche de céramique, et des circuits imprimés;
dans lequel le second boîtier est empilé sur le premier boîtier, avec l'ensemble de broches de connecteur du second boîtier logées dans l'ensemble de réceptacles du premier boîtier.

8. Dispositif suivant la revendication 7, dans lequel le second moyen de connexion comprend des trous métallisés (17a, 17b) dans les première et seconde couches de céramique (16c, 16b), et le troisième moyen de connexion comprend des trous métallisés (27a, 27b) dans les quatrième et cinquième couches de céramique (24, 26).

9. Dispositif suivant l'une quelconque des revendications précédentes, dans lequel :
le compteur d'instructions (114a) comprend un compteur d'instructions de bloc (114a), un compteur d'instructions de page (114b), un compteur d'instructions de pas (114c), un pointeur de nouveau bloc (114d), et un pointeur de nouvelle page (114e).
